# FASCICULE DE BREVET EUROPEEN

(11) **EP 4 260 073 B1**
(45) Date de publication et mention de la délivrance du brevet: **06.11.2024**
(21) Numéro de dépôt: 21840655.1
(22) Date de dépôt: 07.12.2021
(51) Int. Cl.: G01R 15/18

(54) **CAPTEUR DE COURANT BOBINE DEUX EN UN**
STROMFÜHLER MIT ZWEI IN EINS SPULE
TWO-IN-ONE COIL CURRENT SENSOR

(30) Priorité: 14.12.2020 FR 2013172
(43) Date de publication de la demande: 18.10.2023
(73) Titulaire: Safran Electrical & Power, 31702 Blagnac (FR)
(72) Inventeur: CIMA, Lionel, 77550 MOISSY-CRAMAYEL (FR)
(74) Mandataire: Cabinet Beau de Loménie
(86) Numéro de dépôt international: PCT/FR2021/052227
(87) Numéro de publication internationale: WO 2022/129732

(56) Documents cités:
- EP-B1- 2 905 627
- EP-B1- 3 314 281
- MARRACCI MIRKO ET AL: "Study and characterization of a Rogowski coil with superparamagnetic magnetite core", 2017 IEEE INTERNATIONAL INSTRUMENTATION AND MEASUREMENT TECHNOLOGY CONFERENCE (I2MTC), IEEE, 22 May 2017 (2017-05-22), pages 1 - 6, XP033115182, DOI: 10.1109/I2MTC.2017.7969951

## Description

### Domaine Technique

La présente invention se rapporte au domaine général des capteurs de courant et plus particulièrement à un capteur de courant permettant de réaliser deux mesures de courant.

### Technique antérieure

Afin de mesurer des courants dans des conducteurs, on utilise des capteurs de type Effet Néel@ ou de type Rogowski. La technologie Effet Néel^{®} est peu sensible aux champs extérieurs. Elle permet de mesurer des courants continus. Tandis que la technologie Rogowski permet de mesurer des courants alternatifs et de réaliser des capteurs compacts insensibles aux composantes continues du courant du fait de l'absence de noyau magnétique et couvrant une large gamme de fréquence. Néanmoins, les capteurs de type Rogowski sont sensibles aux variations de température.

Un capteur de type Effet Néel@, tel que décrit dans le brevet EP 3 314 281, comprend deux paires de bobines à noyaux parcourus par un courant continu et deux courants alternatifs de fréquences différentes afin d'améliorer le rapport signal à bruit du capteur et ainsi mesurer de faibles valeurs de courant. Afin d'augmenter la bande passante du capteur et de mesurer des courants alternatifs, on peut y ajouter une mesure de type Rogowski. Néanmoins, les bobines de ce capteur ne sont pas utilisables pour réaliser les deux types de mesure du fait de leur triple excitation en courant. Il faut donc ajouter des bobines supplémentaires pour la mesure de type Rogowski, ce qui rend le capteur plus encombrant et plus onéreux.

Il est donc souhaitable de disposer d'un capteur de courant compact, insensible à la température et permettant de réaliser une double mesure de courant.

### Exposé de l'invention

L'invention concerne un capteur de courant comprenant :
- une paire de bobines électriques identiques à noyaux superparamagnétiques et entourées d'une tresse de blindage commune ;
- un moyen d'excitation en courant continu configuré pour faire circuler un courant continu dans au moins une des bobines de la paire de bobines et un moyen d'ajustement d'une intensité du courant continu ;
- un premier moyen d'excitation en courant alternatif configuré pour faire circuler un courant alternatif à une première fréquence dans les bobines de la paire parcourues par le courant continu ;
- un deuxième moyen d'excitation en courant alternatif configuré pour faire circuler un courant alternatif à une deuxième fréquence supérieure à la première fréquence dans les deux bobines de la paire de bobines ; et
- un moyen de mesure d'une force électromotrice de type Effet Néel^{®} aux bornes des deux bobines de la paire.

Les noyaux sont superparamagnétiques, ce qui signifie que le matériau les composant est un matériau magnétique non-linéaire qui ne présente pas d'hystérèse lorsque le champ magnétique appliqué à ce matériau varie périodiquement. Le matériau constituant les noyaux est, par exemple, un composite chargé de nanoparticules superparamagnétiques.

Le capteur de courant selon l'invention permet de déterminer un courant parcourant un conducteur placé au centre des bobines ou à proximité des bobines.

Le moyen de mesure d'une force électromotrice de type Effet Néel^{®} permet de mesurer une composante de tension électrique existant aux bornes des deux bobines de la paire. La force électromotrice de type Effet Néel^{®} que l'on mesure est proportionnelle à la différence entre le courant que l'on cherche à déterminer et le courant de contre-réaction, généré par le moyen d'excitation en courant continu. Ainsi, en faisant varier le courant continu d'excitation (c'est-à-dire le courant de contre-réaction), on peut annuler la force électromotrice mesurée de type Effet Néel^{®} et ainsi déterminer la composante continue de la valeur de courant cherchée. Le capteur de courant selon l'invention permet ainsi de réaliser avec une seule paire de bobines une mesure de courant. Cela permet d'obtenir un capteur plus compact, moins onéreux et plus économe en énergie que celui présenté dans le brevet EP 3 314 281, ce qui est avantageux, et en particulier pour la mesure de forts courants, par exemple des courants supérieurs à 50 A.

Selon un mode de réalisation de l'invention, le capteur comprend en outre une deuxième paire de bobines électriques à noyaux superparamagnétiques identique à la première paire, les moyens d'excitation étant, respectivement, configurés pour faire circuler un courant continu dans au moins une des bobines de la deuxième paire, un courant alternatif à la première fréquence dans les bobines de la deuxième paire parcourues par le courant continu et un courant alternatif à la deuxième fréquence dans les deux bobines de la deuxième paire.

Cette deuxième paire permet par exemple d'augmenter le rapport signal à bruit et ainsi d'améliorer les mesures de force électromotrice et donc de courant.

Selon l'invention, le capteur comprend également un moyen de mesure d'une force électromotrice de type Rogowski aux bornes d'au moins une bobine d'une des paires non parcourue par le courant continu et par le courant alternatif à la première fréquence.

La présence d'un moyen de mesure de type Rogowski permet de réaliser une double mesure de courant : une première basée sur l'Effet Néel^{®} et une deuxième basée sur l'effet Rogowski. La force électromotrice mesurée de type Rogowski est proportionnelle à la dérivée temporelle du courant que l'on cherche à déterminer. Ainsi le capteur de courant permet de déterminer à la fois la composante continue et la composante alternative du courant cherché. La bobine non parcourue par le courant continu et utilisée pour la mesure de la force électromotrice de type Rogowski permet d'éliminer l'effet Rogowski dans la mesure de la force électromotrice selon l'Effet Néel@.

De plus, en ajoutant une deuxième paire de bobines, on peut réaliser une mesure différentielle de courant selon l'effet Rogowski.

Selon une caractéristique particulière de l'invention, le capteur comprend un moyen de correction automatique d'une sensibilité du moyen de mesure d'une force électromotrice de type Rogowski.

La sensibilité de la mesure d'une force électromotrice de type Rogowski, donc d'un capteur de type Rogowski, est proportionnelle à l'inductance mutuelle entre le conducteur dans lequel circule le courant à mesurer et les bobines de mesure. Cette inductance mutuelle est la même pour toutes les bobines, qu'elles soient utilisées pour la mesure d'une force électromotrice de type Effet Néel@ ou de type Rogowski. Or l'inductance mutuelle varie légèrement en fonction de la température, notamment à cause d'une dilatation de la section des spires des bobines. Ce phénomène est relativement faible, mais devient visible lorsque l'on cherche à avoir un capteur de courant précis sur une large plage de température, par exemple entre -40°C et +85°C. Ainsi le moyen de correction permet de corriger automatiquement la sensibilité de la mesure de la force électromotrice de type Rogowski pour obtenir un capteur de courant insensible à la température.

Selon un mode de réalisation de l'invention, le capteur comprend deux paires de bobines ainsi qu'un moyen de mesure d'une force électromotrice de type Rogowski, comme décrit précédemment, et le moyen d'excitation en courant continu et le premier moyen d'excitation en courant alternatif sont configurés pour faire circuler, respectivement, un courant continu et un courant alternatif à la première fréquence dans une seule des bobines de chaque paire, et le moyen de mesure d'une force électromotrice de type Rogowski comprend deux entrées reliées à chaque bobine de chaque paire non parcourue par le courant continu et le courant alternatif à la première fréquence
Les deux entrées du moyen de mesure d'une force électromotrice de type Rogowski reliées chacune à l'une des bobines des deux paires permettent de réaliser une mesure différentielle de cette force électromotrice. La mesure différentielle permet d'améliorer l'immunité du capteur en environnement électromagnétique sévère.

Selon un mode de réalisation de l'invention, le capteur comprend deux paires de bobines comme décrit précédemment, et également deux moyens d'excitation en courant continu configurés pour faire circuler chacun un courant continu dans les bobines de chaque paire, des moyens d'ajustement d'une intensité des courants continus d'excitation, et deux moyens de mesure d'une force électromotrice de type Effet Néel^{®} aux bornes des deux bobines de chaque paire.

La présence des deux moyens d'excitation en courant continu et des deux moyens de mesure d'une composante d'une tension permettent ainsi de réaliser une double mesure de courant par la mesure de deux forces électromotrices selon l'Effet Néel@. On peut ainsi, par exemple, à partir des courants résiduel (ou courant de mode commun) et de réseau (ou courant de mode différentiel) d'un réseau électrique, générer deux courants de contre-réaction, qui fourniront deux mesures distinctes de force électromotrice selon l'Effet Néel^{®}. Cela permet d'atténuer les effets de nonlinéarité dus à une non-homogénéité des champs magnétiques dans les deux paires de bobines.

Selon un mode de réalisation de l'invention, le capteur de courant comprend :
- quatre paires identiques de bobines électriques, au sein de chaque paire, les bobines sont à noyaux superparamagnétiques et chaque paire est entourée d'une tresse de blindage commune aux deux bobines de la paire ;
- deux moyens d'excitation en courant continu, chacun étant configuré pour faire circuler un courant continu dans une seule des bobines de chaque paire, et au moins un moyen d'ajustement d'une intensité du courant continu fourni par chaque moyen d'excitation en courant continu ;
- un premier moyen d'excitation en courant alternatif configuré pour faire circuler un courant alternatif à une première fréquence dans les bobines de chaque paire parcourues par les courants continus d'excitation ;
- un deuxième moyen d'excitation en courant alternatif configuré pour faire circuler un courant alternatif à une deuxième fréquence supérieure à la première fréquence dans les deux bobines de chaque paire ;
- deux moyens de mesure d'une force électromotrice de type Effet Néel@, le premier moyen de mesure étant configuré pour mesurer une dite force électromotrice de type Effet Néel^{®} aux bornes des bobines de deux premières paires et le deuxième moyen de mesure étant configuré pour mesurer une dite force électromotrice de type Effet Néel^{®} aux bornes des bobines des deux autres paires ; et
- deux moyens de mesure d'une force électromotrice de type Rogowski aux bornes d'une bobine non parcourue par un courant continu, les deux moyens comprenant chacun deux entrées, les entrées du premier étant reliées aux bobines non parcourues par les courants continus d'excitation des deux premières paires et les entrées du deuxième étant reliées aux bobines non parcourues par les courants continus d'excitation des deux autres paires.

Cela permet de réaliser deux mesures d'une force électromotrice de type Effet Néel^{®} et deux mesures différentielles d'une force électromotrice de type Rogowski. On a ainsi deux transducteurs, chaque transducteur comprenant deux paires de bobines et deux moyens de mesure d'une force électromotrice selon l'Effet Néel^{®} et de type Rogowski, complètement distincts au sein du capteur. L'un des transducteurs est dédié par exemple à la mesure d'un courant résiduel et l'autre à la mesure d'un courant de réseau d'un réseau électrique, tout en mutualisant les moyens d'excitation en courant pour les deux transducteurs.

Selon une caractéristique particulière de l'invention, la première fréquence est une fréquence basse fréquence, c'est-à-dire qu'elle est comprise entre 10 Hz à 100 kHz.

Selon une autre caractéristique particulière de l'invention, la deuxième fréquence est une fréquence haute fréquence, c'est-à-dire qu'elle est supérieure à 100 kHz.

Un autre objet de l'invention est un procédé de mesure d'un courant circulant dans un conducteur comprenant les étapes suivantes :
- disposer les paires de bobines d'un capteur de courant selon l'invention autour du conducteur parcouru par le courant que l'on souhaite mesurer ;
- activer simultanément les premier et deuxième moyens d'excitation en courant alternatif et les moyens d'excitation en courant continu, et ajuster l'intensité des courants continus du moyen d'excitation en courant continu, de manière à annuler une amplitude d'une force électromotrice de type Effet Néel^{®} mesurée.

Le procédé selon l'invention permet de déterminer un courant circulant dans un conducteur grâce à l'utilisation d'un capteur de courant selon l'invention, notamment au moins la composante continue et éventuellement la composante alternative si un moyen de mesure d'une force électromotrice de type Rogowski est présent dans le capteur.

### Brève description des dessins

D'autres caractéristiques et avantages de la présente invention ressortiront de la description faite ci-dessous, en référence aux dessins annexés qui en illustrent des exemples de réalisation dépourvus de tout caractère limitatif.
[Fig. 1] La figure 1 représente, de manière schématique et partielle, un capteur de courant selon un mode de réalisation de l'invention comprenant un moyen de mesure d'une force électromotrice de type Effet Néel^{®} et un moyen de mesure d'une force électromotrice de type Rogowski.
[Fig. 2] La figure 2 représente, de manière schématique et partielle, un capteur de courant selon un mode de réalisation de l'invention comprenant un moyen de mesure d'une force électromotrice de type Effet Néel^{®} et un moyen de mesure différentielle d'une force électromotrice de type Rogowski.
[Fig. 3] La figure 3 représente, de manière schématique et partielle, un capteur de courant selon un mode de réalisation de l'invention comprenant deux moyens de mesure d'une force électromotrice de type Effet Néel@.
[Fig. 4] La figure 4 représente, de manière schématique et partielle, un capteur de courant selon un mode de réalisation de l'invention comprenant deux moyens de mesure d'une force électromotrice de type Effet Néel@ et deux moyens de mesure différentielle d'une force électromotrice de type Rogowski.

### Description des modes de réalisation

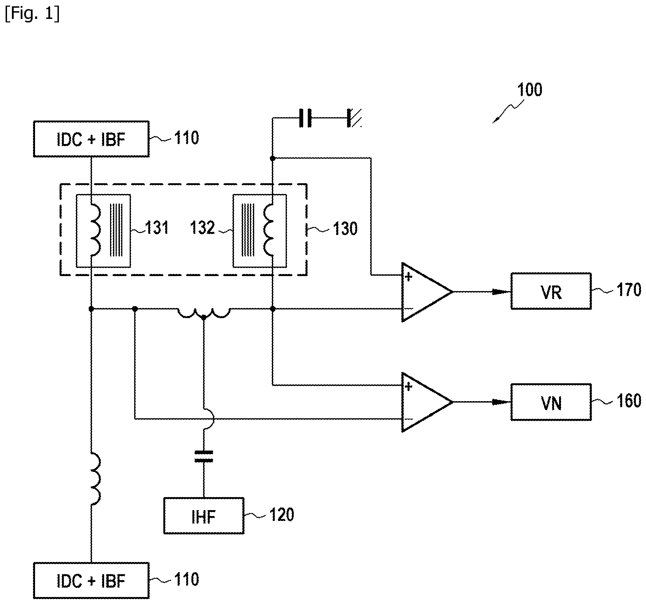

La figure 1 représente, de manière schématique et partielle, un capteur de courant selon un premier mode de réalisation de l'invention.

Le capteur 100 comprend une paire 130 de bobines 131, 132. Les deux bobines 131, 132 sont identiques et comprennent chacune un noyau superparamagnétique. Les deux bobines 131, 132 sont entourées d'une tresse de blindage commune, afin d'apporter aux bobines 131, 132 une immunité aux perturbations électromagnétiques. Le capteur 100 comprend également trois moyens d'excitation des bobines 131, 132 en courant. Le moyen d'excitation 110 est un moyen d'excitation en courant continu IDC et en courant alternatif IBF à une première fréquence pour la bobine 131 de la paire de bobines 130. Le moyen d'excitation 120 est un moyen d'excitation en courant alternatif IHF à une deuxième fréquence supérieure à la première fréquence pour chaque bobine 131 et 132 de la paire 130 de bobines. Ainsi un courant continu et deux courants alternatifs aux première et deuxième fréquences parcourent la bobine 131, et seul un courant alternatif à la deuxième fréquence parcourt la bobine 132.

Le capteur 100 comprend également deux moyens de mesure d'une force électromotrice : le premier 160 permet de mesurer une force électromotrice selon l'Effet Néel^{®} et le deuxième 170 permet de mesurer une force électromotrice de type Rogowski. Le premier moyen de mesure 160 mesure ainsi une force électromotrice VN aux bornes des deux bobines 131 et 132. Tandis que le deuxième moyen de mesure 170 mesure une force électromotrice VR aux bornes de la bobine 132 parcourue uniquement par le courant alternatif à la deuxième fréquence.

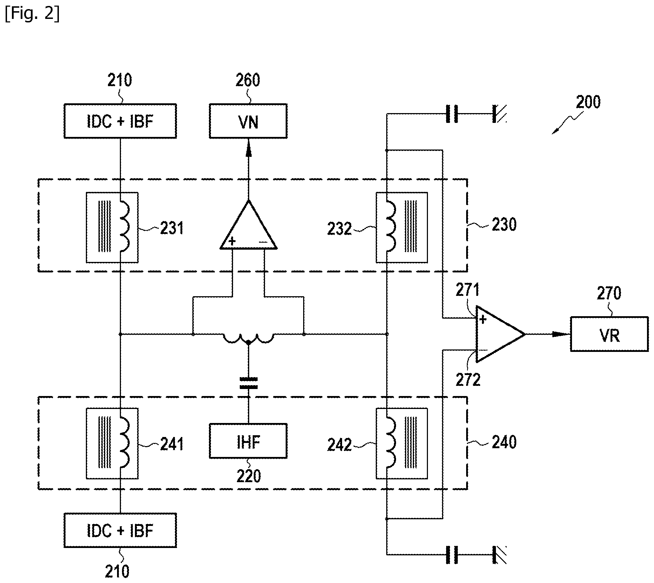

La figure 2 représente, de manière schématique et partielle, un capteur de courant selon un second mode de réalisation de l'invention.

Le capteur 200 comprend deux paires 230, 240 de bobines 231, 232, 241 et 242. Les quatre bobines 231, 232, 241 et 242 sont identiques et comprennent chacune un noyau superparamagnétique. Les deux bobines 231, 232 ou 241, 242 d'une même paire 230 ou 240 sont entourées d'une tresse de blindage commune, afin d'apporter aux bobines une immunité aux perturbations électromagnétiques. Le capteur 200 comprend également trois moyens d'excitation en courant des bobines 231, 232, 241 et 242. Le moyen d'excitation 210 est un moyen d'excitation en courant continu IDC et en courant alternatif IBF à une première fréquence pour la bobine 231 de la paire de bobines 230 et pour la bobine 241 de la paire de bobines 240. Le moyen d'excitation 220 est un moyen d'excitation en courant alternatif IHF à une deuxième fréquence supérieure à la première fréquence pour toutes les bobines 231, 232, 241 et 242 des deux paires 230, 240. Ainsi un courant continu et deux courants alternatifs aux première et deuxième fréquences parcourent les bobines 231 et 241, et seul un courant alternatif à la deuxième fréquence parcourt les bobines 232 et 242.

Le capteur 200 comprend également deux moyens de mesure d'une force électromotrice : le premier 260 permet de mesurer une force électromotrice selon l'Effet Néel^{®} et le deuxième 270 permet de mesurer une force électromotrice de type Rogowski. Le moyen de mesure 270 de type Rogowski comprend deux entrées 271 et 272 reliées chacune à une bobine non parcourue par le courant continu. Ainsi l'entrée 271 est reliée à la bobine 232 et l'entrée 272 est reliée à la bobine 242. Le premier moyen de mesure 260 mesure ainsi une force électromotrice VN aux bornes des deux bobines 231, 232 et 241, 242 de chaque paire 230, 240. Tandis que le deuxième moyen de mesure 270 mesure une force électromotrice VR, de manière différentielle, aux bornes des bobines 232 et 242 parcourues uniquement par le courant alternatif à la deuxième fréquence.

Par rapport au capteur 100 de la figure 1, celui-ci permet de réaliser une mesure différentielle de la force électromotrice de type Rogowski et d'augmenter la puissance du signal grâce aux deux paires 230, 240 de bobines 231, 232, 241 et 242 pour la mesure de la force électromotrice selon l'Effet Néel^{®}.

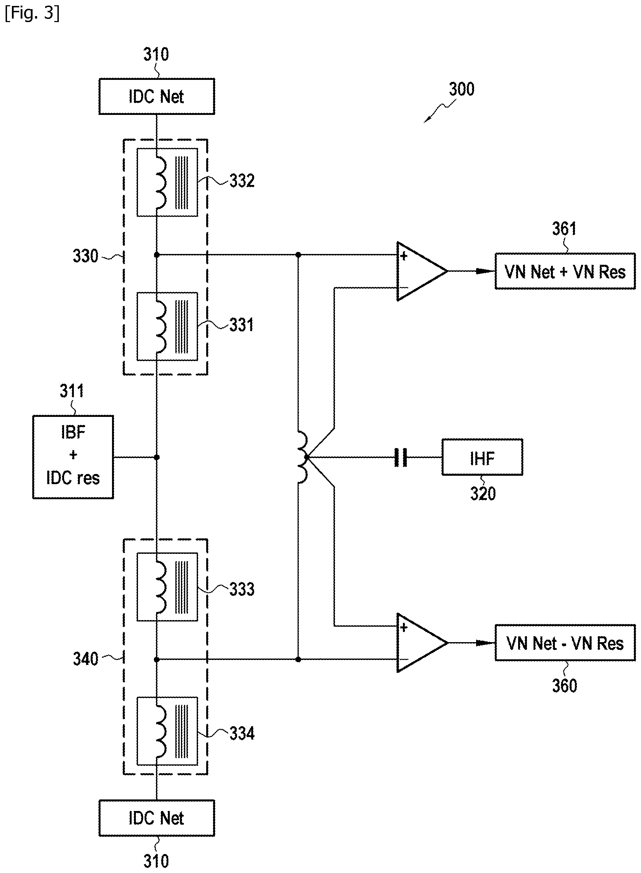

La figure 3 représente, de manière schématique et partielle, un capteur de courant selon un troisième mode de réalisation de l'invention.

Le capteur 300 comprend deux paires 330, 340 de bobines 331, 332, 333 et 334. Les quatre bobines 331, 332, 333 et 334 sont identiques et comprennent chacune un noyau superparamagnétique. Les deux bobines d'une même paire sont entourées d'une tresse de blindage commune, afin d'apporter aux bobines une immunité aux perturbations électromagnétiques. Le capteur 300 comprend également quatre moyens d'excitation en courant des bobines 331 à 334. Le moyen d'excitation 311 est un moyen d'excitation en courant continu IDC Res et en courant alternatif IBF à une première fréquence pour toutes les bobines 331, 332, 333, 334 des deux paires 330 et 340. Le moyen d'excitation 310 est un moyen d'excitation en courant continu IDC Net pour toutes les bobines 331 à 334 des deux paires 330 et 340. Le moyen d'excitation 320 est un moyen d'excitation en courant alternatif IHF à une deuxième fréquence supérieure à la première fréquence pour toutes les bobines 331 à 334. Ainsi deux courants continus et deux courants alternatifs aux première et deuxième fréquences parcourent les quatre bobines.

Le capteur 300 comprend également deux moyens de mesure 360 et 361 d'une force électromotrice selon l'Effet Néel@. Le premier moyen 361 permet de mesurer une force électromotrice VN Net + VN Res proportionnelle à la somme des deux courants continus, tandis que le deuxième 360 permet de mesurer une force électromotrice VN Net - VN Res proportionnelle à la différence entre les deux courants continus. Ainsi en sommant ou en soustrayant ces deux forces électromotrices, on peut déterminer le courant circulant dans un conducteur placé à proximité des bobines ou au centre des bobines. Les deux courants continus d'excitation sont, par exemple, les courants de réseau et résiduel d'un réseau électrique.

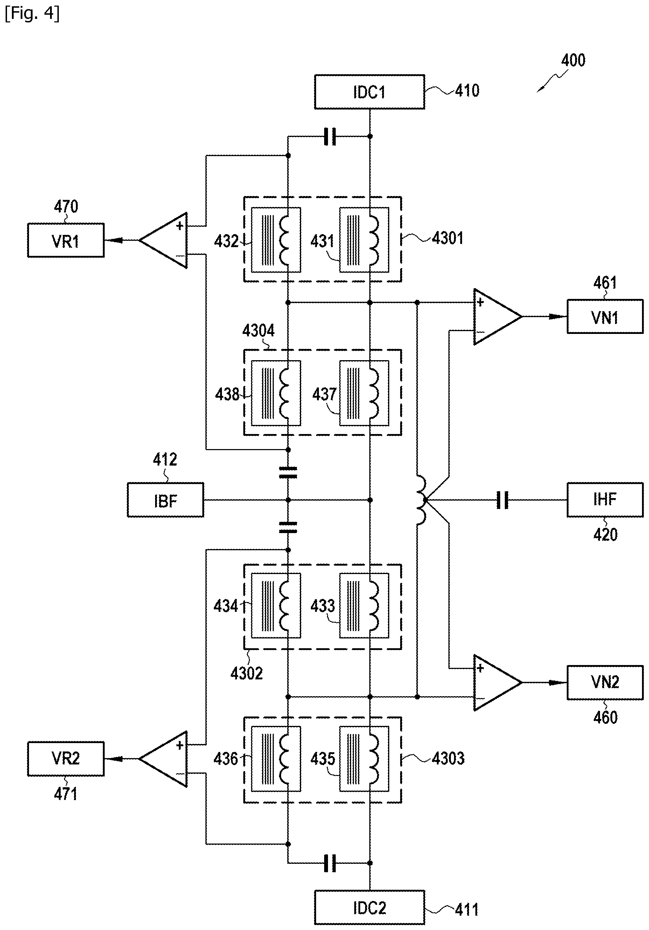

La figure 4 représente, de manière schématique et partielle, un capteur de courant selon un quatrième mode de réalisation de l'invention.

Le capteur 400 comprend quatre paires 4301, 4302, 4303, 4304 de bobines 431 à 438. Les huit bobines sont identiques et comprennent chacune un noyau superparamagnétique. La première paire 4301 comprend ainsi les bobines 431 et 432, la deuxième paire 4302 comprend les bobines 433 et 434, la troisième paire 4303 comprend les bobines 435 et 436 et la quatrième paire 4304 comprend les bobines 437 et 438. Les deux bobines de chaque paire sont entourées d'une tresse de blindage commune, afin d'apporter aux bobines une immunité aux perturbations électromagnétiques.

Le capteur 400 comprend également quatre moyens d'excitation en courant des noyaux des bobines. Le moyen d'excitation 410 est un moyen d'excitation en courant continu IDC1, le moyen d'excitation 411 est un moyen d'excitation en courant continu IDC2, le moyen d'excitation 412 est un moyen d'excitation en courant alternatif IBF à une première fréquence, et le moyen d'excitation 420 est un moyen d'excitation en courant alternatif à une deuxième fréquence supérieure à la première fréquence.

Le moyen d'excitation 410 permet de faire circuler le courant continu IDC1 dans une seule des bobines 431, 433, 435 et 437 de chaque paire 4301 à 4304. Le moyen d'excitation 411 permet de faire circuler le courant continu IDC2 dans une seule des bobines 431, 433, 435 et 437 de chaque paire 4301 à 4304. Le moyen d'excitation 412 permet de faire circuler le courant alternatif IBF à une première fréquence dans les bobines 431, 433, 435 et 437 des paires parcourues par les courants continus d'excitation IDC1 et IDC2.

Le moyen d'excitation 420 permet de faire circuler un courant alternatif IHF à une deuxième fréquence supérieure à la première fréquence dans toutes les bobines 431 à 438 de chaque paire 4301 à 4304 de bobines.

Le capteur 400 comprend également quatre moyens de mesure d'une force électromotrice : deux moyens de mesure 460 et 461 permettent de mesurer une force électromotrice selon l'Effet Néel^{®} dans les deux bobines de chaque paire et les deux autres 470 et 471 permettent de mesurer une force électromotrice de type Rogowski dans les bobines non parcourues par les courants continus. Le moyen 461 mesure ainsi une force électromotrice VN1 selon l'Effet Néel^{®} dans les bobines 431, 432, 437 et 438 des paires 4301 et 4304, tandis que le moyen 460 mesure une force électromotrice VN2 selon l'Effet Néel^{®} dans les bobines 433, 434, 435 et 436 des paires 4302 et 4303. Le moyen 470 mesure une force électromotrice VR1 de type Rogowski dans les bobines 432 et 438 des paires 4301 et 4304, tandis que le moyen 471 mesure une force électromotrice VR2 de type Rogowski dans les bobines 434 et 436 des paires 4302 et 4303. Les deux moyens 470 et 471 comprennent chacun deux entrées de manière à réaliser une mesure différentielle.

Dans tous les modes de réalisation décrits, le capteur de courant comprend également au moins un moyen d'ajustement de l'intensité du ou des courants continus d'excitation. Cela va permettre d'annuler la force électromotrice selon l'Effet Néel^{®} et ainsi déterminer la composante continue du courant cherché.

Dans tous les modes de réalisation, le capteur de courant peut comprendre un ou plusieurs moyens de mesure du courant continu d'excitation fourni par l'un ou les moyens d'excitation en courant continu du capteur.

Dans tous les modes de réalisation comprenant un moyen de mesure d'une force électromotrice de type Rogowski, le capteur peut comprendre un moyen de correction automatique de la sensibilité de ce moyen de mesure.

Le moyen de correction peut, par exemple, corriger la dérive thermique du moyen de mesure de type Rogowski grâce à la mesure de l'inductance des bobines parcourues par un courant continu. En effet, les bobines étant toutes identiques et à la même température ambiante, elles ont des inductances mutuelles identiques. A partir de la mesure de l'impédance, en particulier de l'inductance des bobines parcourue par un courant continu, on peut déterminer le rapport de transformation du moyen de mesure de type Rogowski et donc corriger la dérive en température et la sensibilité de ce moyen de mesure.

Un capteur selon l'invention permet ainsi de mesurer un courant circulant dans un conducteur. Le procédé de mesure associé comprend les étapes suivantes :
- disposer les paires de bobines d'un capteur de courant selon l'invention autour du conducteur parcouru par le courant que l'on souhaite mesurer ;
- activer simultanément les premier et deuxième moyens d'excitation en courant alternatif et les moyens d'excitation en courant continu, et ajuster l'intensité des courants continus du moyen d'excitation en courant continu, de manière à annuler une amplitude d'une force électromotrice de type Effet Néel^{®} mesurée.

En annulant l'amplitude de la force électromotrice de type Effet Néel@, on peut ainsi déterminer la composante continue du courant circulant dans le conducteur qui sera égale au courant de contre-réaction, c'est-à-dire au courant généré par le moyen d'excitation en courant continu du capteur.

## Revendications

1. Capteur de courant (100, 200, 300, 400) comprenant :
- une paire (130, 230, 330, 4301) de bobines électriques (131, 132, 231, 232, 331, 332, 431, 432) identiques à noyaux superparamagnétiques et entourées d'une tresse de blindage commune ;
- un moyen d'excitation en courant continu (110, 210, 310, 410) configuré pour faire circuler un courant continu (IDC, IDC Res, IDC1) dans au moins une (131, 231, 331, 332, 431) des bobines de la paire de bobines et un moyen d'ajustement d'une intensité du courant continu ;
- un premier moyen d'excitation en courant alternatif (110, 210, 311, 412) configuré pour faire circuler un courant alternatif (IBF) à une première fréquence dans les bobines (131, 231, 331, 332, 431) de la paire parcourues par le courant continu ;
- un deuxième moyen d'excitation en courant alternatif (120, 220, 320, 420) configuré pour faire circuler un courant alternatif (IHF) à une deuxième fréquence supérieure à la première fréquence dans les deux bobines (131, 132, 231, 232, 331, 332, 431, 432) de la paire de bobines ;
- un moyen de mesure (160, 260, 361, 461) d'une force électromotrice de type Effet Néel (VN, VN Net + VN Res, VN1) aux bornes des deux bobines (131, 132, 231, 232, 331, 332, 431, 432) de la paire, et
- un moyen de mesure (170, 270) d'une force électromotrice de type Rogowski (VR) aux bornes d'au moins une des bobines (132, 232, 242) d'une des paires (130, 230, 240) non parcourue par le courant continu (IDC) et par le courant alternatif (IBF) à la première fréquence.

2. Capteur de courant (200, 300, 400) selon la revendication 1, comprenant en outre une deuxième paire (240, 340, 4302) de bobines électriques (241, 242, 333, 334, 433, 434) à noyaux superparamagnétiques identique à la première paire, les moyens d'excitation étant, respectivement, configurés pour faire circuler un courant continu dans au moins une des bobines (241) de la deuxième paire (240), un courant alternatif à la première fréquence dans les bobines (241) de la deuxième paire (240) parcourues par le courant continu et un courant alternatif à la deuxième fréquence dans les deux bobines (241, 242) de la deuxième paire (240).

3. Capteur de courant selon l'une quelconque des revendications 1 ou 2, comprenant un moyen de correction automatique d'une sensibilité du moyen de mesure d'une force électromotrice de type Rogowski.

4. Capteur de courant (200) selon l'une des revendications 1 à 3 en combinaison avec la revendication 2, dans lequel le moyen d'excitation (210) en courant continu et le premier moyen d'excitation (210) en courant alternatif sont configurés pour faire circuler, respectivement, un courant continu (IDC) et un courant alternatif (IBF) à la première fréquence dans une seule des bobines (231, 241) de chaque paire (230, 240), et le moyen de mesure (270) d'une force électromotrice de type Rogowski comprend deux entrées (271, 272) reliées à chaque bobine (232, 242) de chaque paire non parcourue par le courant continu et le courant alternatif à la première fréquence.

5. Capteur de courant (400) selon l'une quelconque des revendications 1 à 4, comprenant :
- quatre paires identiques (4301, 4302, 4303, 4304) de bobines électriques (431 à 438), au sein de chaque paire, les bobines sont à noyaux superparamagnétiques et chaque paire est entourée d'une tresse de blindage commune aux bobines de la paire ;
- deux moyens d'excitation en courant continu (410, 411), chacun étant configuré pour faire circuler un courant continu (IDC1, IDC2) dans une seule (431, 433, 435, 437) des bobines de chaque paire (4301 à 4304), et au moins un moyen d'ajustement d'une intensité du courant continu fourni par chaque moyen d'excitation en courant continu ;
- un premier moyen d'excitation en courant alternatif (412) configuré pour faire circuler un courant alternatif (IBF) à une première fréquence dans les bobines (431, 433, 435, 437) de chaque paire (4301 à 4304) parcourues par les courants continus d'excitation (IDC1, IDC2) ;
- un deuxième moyen d'excitation en courant alternatif (420) configuré pour faire circuler un courant alternatif (IHF) à une deuxième fréquence supérieure à la première fréquence dans les deux bobines (431 à 438) de chaque paire de bobines (4301 à 4304) ;
- deux moyens de mesure (460, 461) d'une force électromotrice de type Effet Néel (VN1, VN2), le premier moyen de mesure (461) étant configuré pour mesurer une dite force électromotrice de type Effet Néel (VN1) aux bornes des bobines (431, 437) de deux premières paires (4301, 4304) et le deuxième moyen de mesure (460) étant configuré pour mesurer une dite force électromotrice de type Effet Néel (VN2) aux bornes des bobines (433, 435) des deux autres paires (4302, 4303) ; et
- deux moyens de mesure (470, 471) d'une force électromotrice de type Rogowski (VR1, VR2) aux bornes de deux bobines (432, 438 et 434, 436) non parcourues par un courant continu, les deux moyens comprenant chacun deux entrées, les entrées du premier étant reliées aux bobines (432, 438) non parcourues par les courants continus d'excitation (IDC1, IDC2) des deux premières paires (4301, 4304) et les entrées du deuxième étant reliées aux bobines (434, 436) non parcourues par les courants continus d'excitation (IDC1, IDC2) des deux autres paires (4302, 4303).

6. Procédé de mesure d'un courant circulant dans un conducteur comprenant les étapes suivantes :
- disposer les paires de bobines d'un capteur de courant selon l'une quelconque des revendications 1 à 5 autour du conducteur parcouru par le courant que l'on souhaite mesurer ;
- activer simultanément les premier et deuxième moyens d'excitation en courant alternatif et les moyens d'excitation en courant continu, et ajuster l'intensité des courants continus du moyen d'excitation en courant continu, de manière à annuler une amplitude d'une force électromotrice de type Effet Néel mesurée.

## Patentansprüche

1. Stromfühler (100, 200, 300, 400), umfassend:
- ein Paar (130, 230, 330, 4301) identische elektrische Spulen (131, 132, 231, 232, 331, 332, 431, 432) mit superparamagnetischen Kernen, die von einem gemeinsamen Abschirmungsgeflecht umgeben sind;
- ein Gleichstromerregungsmittel (110, 210, 310, 410), das ausgelegt ist, um einen Gleichstrom (IDC, IDC Res, IDC1) in mindestens einer (131, 231, 331, 332, 431) der Spulen des Spulenpaares fließen zu lassen, und ein Mittel zum Einstellen einer Stärke des Gleichstroms;
- ein erstes Wechselstromerregungsmittel (110, 210, 311, 412), das ausgelegt ist, um einen Wechselstrom (IBF) mit einer ersten Frequenz in den Spulen (131, 231, 331, 332, 431) des Paares fließen zu lassen, die von dem Gleichstrom durchquert werden;
- ein zweites Wechselstromerregungsmittel (120, 220, 320, 420), das ausgelegt ist, um einen Wechselstrom (IHF) mit einer zweiten Frequenz, die höher ist als die erste Frequenz, in den beiden Spulen (131, 132, 231, 232, 331, 332, 431, 432) des Spulenpaares fließen zu lassen;
- ein Mittel (160, 260, 361, 461) zum Messen einer elektromotorischen Kraft vom Néel-Effekt-Typ (VN, VN Net + VN Res, VN1) an den Klemmen der beiden Spulen (131, 132, 231, 232, 331, 332, 431, 432) des Paares, und
- ein Mittel (170, 270) zum Messen einer elektromotorischen Kraft vom Rogowski Typ (VR) an den Klemmen mindestens einer der Spulen (132, 232, 242) eines der Paare (130, 230, 240), die nicht von dem Gleichstrom (IDC) und von dem Wechselstrom (IBF) mit der ersten Frequenz durchquert werden.

2. Stromfühler (200, 300, 400) nach Anspruch 1, ferner umfassend ein zweites Paar (240, 340, 4302) elektrische Spulen (241, 242, 333, 334, 433, 434) mit superparamagnetischen Kernen, die mit dem ersten Paar identisch sind, wobei die Erregermittel jeweils ausgelegt sind, um einen Gleichstrom in mindestens einer der Spulen (241) des zweiten Paares (240), einen Wechselstrom mit der ersten Frequenz in den Spulen (241) des zweiten Paares (240), die von dem Gleichstrom durchquert werden, und einen Wechselstrom mit der zweiten Frequenz in den beiden Spulen (241, 242) des zweiten Paares (240) fließen zu lassen.

3. Stromfühler nach einem der Ansprüche 1 oder 2, umfassend ein Mittel zur automatischen Korrektur einer Empfindlichkeit des Mittels zum Messen einer elektromotorischen Kraft vom Rogowski-Typ.

4. Stromfühler (200) nach einem der Ansprüche 1 bis 3 in Kombination mit Anspruch 2, wobei das Gleichstromerregungsmittel (210) und das erste Wechselstromerregungsmittel (210) ausgelegt sind, um jeweils einen Gleichstrom (IDC) und einen Wechselstrom (IBF) mit der ersten Frequenz in nur einer der Spulen (231, 241) jedes Paares (230, 240) fließen zu lassen, und das Mittel (270) zum Messen einer elektromotorischen Kraft vom Rogowski-Typ zwei Eingänge (271, 272) umfasst, die mit jeder Spule (232, 242) jedes Paares verbunden sind, die nicht von dem Gleichstrom und von dem Wechselstrom mit der ersten Frequenz durchquert wird.

5. Stromfühler (400) nach einem der Ansprüche 1 bis 4, umfassend:
- vier identische Paare (4301, 4302, 4303, 4304) elektrische Spulen (431 bis 438), wobei innerhalb jedes Paares die Spulen superparamagnetische Kerne aufweisen und jedes Paar von einem Abschirmungsgeflecht umgeben ist, das den Spulen des Paares gemeinsam ist;
- zwei Gleichstromerregungsmittel (410, 411), die jeweils ausgelegt sind, um einen Gleichstrom (IDC1, IDC2) in nur einer (431, 433, 435, 437) der Spulen jedes Paares (4301 bis 4304) fließen zu lassen, und mindestens ein Mittel zum Einstellen einer Stärke des Gleichstroms, der von jedem Gleichstromerregungsmittel bereitgestellt wird;
- ein erstes Wechselstromerregungsmittel (412), das ausgelegt ist, um einen Wechselstrom (IBF) mit einer ersten Frequenz in den Spulen (431, 433, 435, 437) jedes Paares (4301 bis 4304) fließen zu lassen, die von den Erregungsgleichströmen (IDC1, IDC2) durchquert werden;
- ein zweites Wechselstromerregungsmittel (420), das ausgelegt ist, um einen Wechselstrom (IHF) mit einer zweiten Frequenz, die höher ist als die erste Frequenz, in den beiden Spulen (431-438) jedes Spulenpaares (4301 bis 4304) fließen zu lassen;
- zwei Mittel (460, 461) zum Messen einer elektromotorischen Kraft vom Néel-Effekt-Typ (VN1, VN2), wobei das erste Messmittel (461) ausgelegt ist, um eine elektromotorische Kraft vom Néel-Effekt-Typ (VN1) an den Klemmen der Spulen (431, 437) von zwei ersten Paaren (4301, 4304) zu messen, und das zweite Messmittel (460) ausgelegt ist, um eine elektromotorische Kraft vom Neel-Effekt-Typ (VN2) an den Klemmen der Spulen (433, 435) der anderen beiden Paare (4302, 4303) zu messen; und
- zwei Mittel (470, 471) zum Messen einer elektromotorischen Kraft vom Rogowski Typ (VR1, VR2) an den Klemmen von zwei Spulen (432, 438 und 434, 436), die nicht von einem Gleichstrom durchquert werden, wobei die beiden Mittel jeweils zwei Eingänge umfassen, wobei die Eingänge des ersten mit den Spulen (432, 438) verbunden sind, die nicht von den Erregungsgleichströmen (IDC1, IDC2) der ersten beiden Paare (4301, 4304) durchquert werden, und die Eingänge des zweiten mit den Spulen (434, 436) verbunden sind, die nicht von den Erregungsgleichströmen (IDC1, IDC2) der anderen beiden Paare (4302, 4303) durchquert werden.

6. Verfahren zum Messen eines in einem Leiter fließenden Stroms, das die folgenden Schritte umfasst:
- Anordnen der Spulenpaare eines Stromfühlers nach einem der Ansprüche 1 bis 5 um den Leiter herum, der von dem Strom durchquert wird, den man messen möchte;
- gleichzeitiges Aktivieren des ersten und zweiten Wechselstromerregungsmittels und der Gleichstromerregungsmittel und Einstellen der Stärke der Gleichströme des Gleichstromerregungsmittels, um eine Amplitude einer gemessenen elektromotorischen Kraft vom Néel-Effekt-Typ aufzuheben.

## Claims

1. A current sensor (100, 200, 300, 400) comprising:
- one pair (130, 230, 330, 4301) of identical electrical coils (131, 132, 231, 232, 331, 332, 431, 432) with superparamagnetic cores and surrounded by a common shielding braid;
- a direct current excitation means (110, 210, 310, 410) configured to make a direct current flow (IDC, IDC Res, IDC1) in at least one (131, 231, 331, 332, 431) of the coils of the pair of coils and a means for adjusting an intensity of the direct current;
- a first alternating current excitation means (110, 210, 311, 412) configured to make an alternating current (IBF) flow at a first frequency in the coils (131, 231, 331, 332, 431) of the pair that the direct current flows through;
- a second alternating current excitation means (120, 220, 320, 420) configured to make an alternating current (IHF) flow at a second frequency greater than the first frequency in both coils (131, 132, 231, 232, 331, 332, 431, 432) of the pair of coils;
- a means of measuring (160, 260, 361, 461) an electromotive force of the Néel Effect type (VN, VN Net + VN Res, VN1) at the terminals of the two coils (131, 132, 231, 232, 331, 332, 431, 432) of the pair, and
- a means of measuring (170, 270) an electromotive force of the Rogowski (VR) type at the terminals of at least one of the coils (132, 232, 242) of one of the pairs (130, 230, 240) that the direct current (IDC) and the alternating current (IBF) does not flow through at the first frequency.

2. The current sensor (200, 300, 400) according to claim 1, also comprising a second pair (240, 340, 4302) of electrical coils (241, 242, 333, 334, 433, 434) with superparamagnetic cores identical to the first pair, the excitation means being, respectively, configured to make a direct current flow in at least one of the coils (241) of the second pair (240), an alternating current at the first frequency in the coils (241) of the second pair (240) that the direct current flows through and an alternating current at the second frequency in both coils (241, 242) of the second pair (240).

3. The current sensor according to any one of claims 1 or 2, comprising an automatic means of correcting a sensitivity of the means for measuring an electromotive force of the Rogowski type.

4. The current sensor (200) according to one of claims 1 to 3 in combination with claim 2, wherein the direct current excitation means (210) and the first alternating current excitation means (210) are configured to make a direct current (IDC) and an alternating current (IBF), respectively, flow at the first frequency in only one of the coils (231, 241) of each pair (230, 240), and the means of measuring (270) an electromotive force of the Rogowski type comprises two inputs (271, 272) connected to each coil (232, 242) of each pair that the direct current and the alternating current at the first frequency do not flow through.

5. The current sensor (400) according to any one of claims 1 to 4, comprising:
- four identical pairs (4301, 4302, 4303, 4304) of electrical coils (431 to 438); within each pair, the coils have superparamagnetic cores and each pair is surrounded by a shielding braid common to the coils of the pair;
- two direct current excitation means (410, 411), each being configured to make a direct current (IDC1, IDC2) flow in only one (431, 433, 435, 437) of the coils of each pair (4301 à 4304), and at least one means of adjusting an intensity of the direct current supplied by each direct current excitation means;
- a first alternating current excitation means (412) configured to make an alternating current (IBF) flow at a first frequency in the coils (431, 433, 435, 437) of each pair (4301 to 4304) that the direct excitation currents (IDC1, IDC2) flow through;
- a second alternating current excitation means(420) configured to make an alternating current (IHF) at a second frequency greater than the first frequency flow in both coils (431 to 438) of each pair of coils (4301 to 4304);
- two means of measuring (460, 461) an electromotive force of the Néel effect type (VN1, VN2), the first measuring means (461) being configured to measure a said electromotive force of the Néel effect (VN1) type at the terminals of the coils (431, 437) of two first pairs (4301, 4304) and the second measuring means (460) being configured to measure a said electromotive force of the Néel effect (VN2) type at the terminals of the coils (433, 435) of the two other pairs (4302, 4303); and
- two means of measuring (470, 471) an electromotive force of the Rogowski type (VR1, VR2) at the terminals of two coils (432, 438 and 434, 436) that a direct current does not flow through, the two means each comprising two inputs, the inputs of the first being connected to the coils (432, 438) that the direct excitation currents (IDC1, IDC2) do not flow through of the two first pairs (4301, 4304) and the inputs of the second being connected to the coils (434, 436) that the direct excitation currents (IDC1, IDC2) do not flow through of the two other pairs (4302, 4303).

6. A method for measuring a current flowing in a conductor, comprising the following steps:
- arranging the pairs of coils of a current sensor according to any one of claims 1 to 5 around the conductor that the current that it is desired to measure flows through;
- activating simultaneously the first and second alternating current excitation means and the direct current excitation means, and adjusting the intensity of the direct currents of the direct current excitation means, so as to cancel an amplitude of a measured electromotive force of the Néel effect type.
